# EUROPÄISCHE PATENTSCHRIFT

(11) **EP 2 876 981 B1**
(45) Veröffentlichungstag und Bekanntmachung des Hinweises auf die Patenterteilung: **06.03.2019**
(21) Anmeldenummer: 14003905.8
(22) Anmeldetag: 20.11.2014
(51) Int. Cl.: H05K 5/02, G09F 3/18

(54) **Gehäusewandelement mit Halterung für ein Etikett**
Housing wall element with holder for a label
Élément mural de boîtier avec support pour une étiquette

(30) Priorität: 22.11.2013 DE 102013019632
(43) Veröffentlichungstag der Anmeldung: 27.05.2015
(73) Patentinhaber: Dätwyler Cabling Solutions AG, 6460 Altdorf (CH)
(72) Erfinder: Arnold, Martin, 5630 Muri (CH)
(74) Vertreter: Samson & Partner Patentanwälte mbB

(56) Entgegenhaltungen:
- EP-A1- 1 347 551
- CH-A- 429 872
- US-A- 4 862 553
- US-A- 5 592 361
- US-A1- 2005 003 700
- US-A1- 2009 148 116

## Beschreibung

### Gebiet der Erfindung

Die Erfindung betrifft ein Gehäusewandelement mit wenigstens einer einteilig mit dem Gehäusewandelement ausgebildeten Halterung für ein Etikett, sowie ein Gehäuse mit einem solchen Gehäusewandelement.

### Hintergrund der Erfindung

Einem Gehäuse lässt sich oftmals nicht der Typ, die Funktionsweise oder eine Konfiguration der in dem Gehäuse angeordneten Vorrichtung ansehen. Außerdem sind an zahlreichen Gehäusen von außen zugängliche Bedienelemente oder Anschlüsse angeordnet, deren Zweck oder Konfiguration gleichfalls schwer oder nicht erkennbar ist.

Es ist bekannt, Gehäuse mit Beschriftungen zu bedrucken oder Etiketten auf das Gehäuse zu kleben. Auch ist bekannt, Etiketten an ein Gehäuse zu schrauben, zu nieten oder mittels zusätzlicher Halterungen an dem Gehäuse zu fixieren. Hierdurch lassen sich Gehäuse und/oder Bedienelemente oder Anschlüsse an einem Gehäuse kennzeichnen. Allerdings lässt sich die Beschriftung bzw. das Etikett nicht oder nur unter hohem Aufwand von dem Gehäuse wieder entfernen.

Die CH 429 872 A beschreibt ein Gehäuse bei dem hinter einer Öffnung eines Gehäuseteiles ein bandförmiger Träger in einer Schiebeführung verstellbar angeordnet ist. Die US 2005/0003700 A1 beschreibt ein Gehäuse mit einem Etikett und einer transparenten Platte.

Der Erfindung liegt die Aufgabe zugrunde, ein Gehäuse bereitzustellen, das solche Nachteile vermeidet oder zumindest reduziert.

### Kurzfassung der Erfindung

Die Erfindung ist durch die unabhängigen Ansprüche definiert.

Ein Aspekt betrifft ein Gehäusewandelement mit wenigstens einer einteilig mit dem Gehäusewandelement ausgebildeten Halterung für ein Etikett. Hierbei ist die Halterung eingerichtet, das Etikett werkzeuglos an dem Gehäusewandelement anzubringen und auch von diesem zu lösen. Zudem weist die Halterung eine Rückhalteeinrichtung auf, um ein selbstständiges Lösen des Etiketts zu verhindern.

Ein weiterer Aspekt betrifft ein Gehäuse mit einem solchen Gehäusewandelement.

### Allgemeine Beschreibung

Die nachfolgende Beschreibung ist gleichermaßen auf das Gehäusewandelement als auch auf das Gehäuse mit dem Gehäusewandelement zu verstehen.

Die Halterung ist einteilig mit dem Gehäusewandelement ausgebildet, sodass keine separaten Bauteile zusätzlich zum Gehäusewandelement nötig sind, um das Etikett an diesem zu befestigen und zu halten. Zudem lässt sich das Etikett werkzeuglos an dem Gehäusewandelement anbringen und bei Bedarf auch wieder von diesem zu lösen. Dies vereinfacht das Anbringen des Etiketts und erlaubt einem Benutzer, das Etikett nach freiem Belieben und ohne Zuhilfenahme spezieller Werkzeuge anzubringen, zu lösen oder auszuwechseln. Außerdem ist die Halterung mit einer Rückhalteeinrichtung zum Festhalten des Etiketts am Gehäuse ausgerüstet, die so eingerichtet ist, dass ein selbstständiges Lösen des Etiketts, sprich ein unbeabsichtigtes Abfallen oder Abrutschen des Etiketts vom Gehäuse bzw. aus der Halterung, verhindert wird. Das Etikett kann beispielsweise nichthaftend oder nicht-selbstklebend sein. Bei manchen Ausgestaltungen ist die Halterung für ein einzelnes Etikett (pro Halterung) ausgerüstet.

Im Übrigen ist die Halterung auf einer Frontwand oder Rückwand des Gehäuses angeordnet, d.h. das Gehäusewandelement ist hierbei eine Frontwand bzw. eine Rückwand. Zudem ist die Halterung vorzugsweise auf einer Außenseite des Gehäusewandelements hinsichtlich des Gehäuses angeordnet. Hierdurch ist das Etikett besonders einfach zugänglich.

Bei manchen Ausgestaltungen ist das Gehäuse nach Art eines teilweise offenen Rahmens gebildet, um einen einfachen Zugang in das Gehäuseinnere zu ermöglichen. Hierbei ist bei manchen Ausgestaltungen nur ein einziges Gehäusewandelement lösbar, wodurch sich die Gefahr eines fehlerhaften Eingriffs reduziert. Bei anderen Ausgestaltungen sind zwei oder mehr Gehäusewandelemente lösbar, wodurch sich ein einfacherer Eingriff in das Gehäuse erzielen lässt.

Bei manchen Ausgestaltungen lässt sich das Gehäuse werkzeuglos (händisch) öffnen oder auch wiederverschließen, etwa indem (wenigstens) ein Gehäusewandelement, z.B. eine Frontwand, eine Rückwand, ein Boden, eine Seitenwand und/oder ein Deckel, an dem Gehäuse werkzeuglos befestigbar oder auch von diesem wieder lösbar ist. Dies ermöglicht einen raschen Zugriff in das Innere des Gehäuses. Bei manchen anderen Ausgestaltungen lässt sich das Gehäuse mittels eins üblichen Werkzeugs, etwa einem Kreuzschlitz- oder Schlitzschraubendreher, öffnen oder auch wiederverschließen.

Bei manchen Ausgestaltungen hat die Halterung eine Ausnehmung zum Einlegen und/oder Einschieben des Etiketts. Vorzugsweise entsprechen sich hierbei die Umrisse der Ausnehmung und des Etiketts, zumindest ist die Ausnehmung vorzugsweise so dimensioniert, dass sich das Etikett vollständig in die Ausnehmung einlegen oder einschieben lässt. Die Ausnehmung ist beispielsweise eine im Querschnittsprofil im Wesentlichen rechteckige Nut.

Wie zuvor genannt, ist die Halterung mit einer Rückhalteeinrichtung ausgerüstet. Bei manchen Ausgestaltungen ist hierzu die Rückhalteeinrichtung mit mindestens einer Schiene zum Einschieben des Etiketts, einer Hinterschneidung, einem Haltefinger, einer Rastnase, einen die Ausnehmung überspannenden Steg und/oder einer Öse ausgerüstet. Hiermit lässt sich das Etikett zumindest teilweise Umgreifen und so durch Formschluss an dem Gehäusewandelement halten. Übrigens ist die Rückhalteeinrichtung gleichfalls einteilig mit dem Gehäusewandelement ausgebildet.

Bei manchen Ausgestaltungen ist die Ausnehmung hinsichtlich ihrer Längsrichtung an einer oder auch an beiden Stirnseiten mit einer Hinterschneidung, z.B. ähnlich einem Sackloch, ausgerüstet. Das Etikett lässt sich so in der Ausnehmung platzieren, dass es in diese (wenigstens eine) Hinterschneidung(en) hineinragt und sich dadurch ein Herausfallen aus der Ausnehmung (zusätzlich) verhindert lässt. Hierbei ist vorzugsweise das Etikett hinsichtlich seiner Länge so dimensioniert, dass es zwangsweise in die Hinterschneidung(en) hineinragt, wenn es in der Ausnehmung angebracht ist. Bei manchen Ausgestaltungen sind die Halterung und eine (der) Hinterschneidung(en) so angeordnet, dass bei einer bevorzugten Orientierung des Gehäuses bzw. bevorzugten Orientierung des Gehäusewandelements das Etikett aufgrund seiner Schwerkraft in Richtung der Hinterschneidung geleitet wird.

Bei manchen Ausgestaltungen ist die Halterung für ein im Wesentlichen streifenförmiges Etikett ausgerüstet. Beispielsweise hat das Etikett eine im Wesentlichen rechteckige Form. Im Übrigen kann die Länge des Etikett(-streifens) beispielsweise 5, 10, 15 oder 20 mal größer sein als die Breite des Etiketts. Trotz einer gegebenenfalls hieraus resultierenden geringen Steifigkeit eines solchen Etiketts lässt sich auch ein solches Etikett mittels der Rückhalteeinrichtung zuverlässig halten.

Bei manchen Ausgestaltungen ist die Halterung mit wenigstens einem Anschlag ausgerüstet. Der Anschlag ist beispielsweise als Vorsprung des Gehäusewandelements so ausgebildet, dass das Etikett im in die Halterung eingelegten Zustand mit einer Stirnseite an dem Vorsprung anliegt. So lässt sich das Etikett an einer gewissen Stelle positionieren.

Bei manchen Ausgestaltungen sind mehrere, beispielsweise zwei, drei, vier, sechs, acht oder zwölf, Halterungen pro Gehäusewandelement vorgesehen, wobei vorzugsweise jede dieser Halterungen zum Halten von jeweils (höchstens) einem Etikett ausgerüstet ist.

Hingegen kann bei manchen Ausgestaltungen wenigstens eine Halterung zum (gleichzeitigen) Halten mehrerer, beispielsweise zwei, drei, vier, sechs, acht oder zwölf, Etiketten ausgerüstet sein. Dementsprechend sind bei manchen Ausgestaltungen mehrere Anschläge so entlang der Ausnehmung angeordnet, dass sich in der Halterung mehrere Etiketten an durch die Anschläge definierten Stellen nebeneinander positionieren lassen. Bei manchen Ausgestaltungen ist die wenigstens eine Halterung so eingerichtet, dass sich die Etiketten in der bzw. den Halterung(en) entlang einer Reihe anordnen lassen. Bei einigen Ausgestaltungen ist die Ausnehmung so lang, das die mehreren Etikette gleichzeitig (hintereinander angeordnet) in die Ausnehmung passen, und zwar vorzugsweise überlappungsfrei.

Bei manchen Ausgestaltungen ragt die Halterung nicht über eine äußere Oberfläche des Gehäusewandelements hinaus. Die Halterung stellt also kein Vorsprung gegenüber dem Gehäusewandelement dar; vorzugsweise ist sie bündig zu einer Außenseite des Gehäusewandelements ausgebildet. Vorzugsweise sind die Ausnehmung und auch das Etikett so dimensioniert, dass das Etikett (ggf. zusammen mit einer Schutzfolie; siehe unten) im in die Halterung eingelegten Zustand von der Außenseite des Gehäusewandelements zurückgesetzt angeordnet ist oder bündig zur Außenseite ist. Hierdurch lässt sich ein Verschleiß des Etiketts vermindern und/oder auch die Gefahr einer Beschädigung der Halterung reduzieren.

Bei manchen Ausgestaltungen ist die Ausnehmung der Halterung über einen Einführschlitz mit einer Außenseite des Gehäusewandelements verbunden, durch den sich das Etikett hindurch in die Ausnehmung einschieben lässt. Vorzugsweise ist der Einführschlitz an einer Stirnfläche des Gehäusewandelements angeordnet. Hierdurch ist er beispielsweise von der Frontseite her gesehen geschützt angeordnet. Bei manchen Ausgestaltungen ist die Frontseite des Gehäusewandelements zu wenigstens einer Seite hin zu ihrem Rand hin stufenartig verjüngt. Hierbei lässt sich der Einführschlitz stirnseitig an einer Stufe anordnen, und zwar beabstandet zum Rand des Gehäusewandelements.

Bei manchen Ausgestaltungen ist in dem Gehäusewandelement wenigstens eine Öffnung angeordnet. Beispielsweise können in einer solchen Öffnung Anschlüsse oder Bedienelemente (für die in dem Gehäuse untergebrachte Vorrichtung) montiert und/oder hindurchgeführt sein. Vorzugsweise sind hierbei die wenigstens eine Halterung und die wenigstens eine Öffnung so angeordnet, dass sich ein von einer Halterung gehaltenes Etikett bei visueller Betrachtung des Gehäusewandelements einer Öffnung (und folglich auch dem Anschluss oder Bedienelement) zuordnen lässt.

Bei manchen Ausgestaltungen ist das Gehäusewandelement mit wenigstens einer Reihe von solchen Öffnungen ausgerüstet. Vorzugsweise ist entlang der Reihe von Öffnungen eine hierzu parallele Reihe von Halterungen angeordnet. Zusätzlich oder alternativ kann auch eine Halterung für mehrere (in einer Reihe angeordnete) Etiketten entlang der Reihe von Öffnungen angeordnet sein.

Bei manchen Ausgestaltungen ist die wenigstens einen Öffnung zur Befestigung von wenigstens einer Lichtwellenleiter-Kupplung, beispielsweise wenigstens einer MTP-Kupplung, wenigstens einer LC-, LCD-, oder LCQ-Kupplung eine E2000-Kupplung und/oder eine Kupplung eines anderen Lichtwellenleiterkupplungstyps, eingerichtet. Hierzu ist beispielsweise beidseitig der Öffnung auf einer Innenseite des Gehäusewandelements wenigstens ein Vorsprung (pro zu befestigender Kupplung) vorgesehen, in den sich eine Rastnase einer solchen Lichtwellenleiter-Kupplung einrasten lässt. Alternativ ist beispielsweise wenigstens eine Rastnase auf der Innenseite des Gehäuseelements angeordnet, welche in eine Ausnehmung einer solchen Lichtwellenleiter-Kupplung einrasten kann, sodass sich diese in der Öffnung befestigen lässt. Insgesamt erlaubt dies eine werkzeuglose Montage einer oder mehrere Lichtwellenleiter-Kupplungen in einer solchen Öffnung.

Ähnlich der Gestalt einer gestrichelten Linie, sind bei manchen Ausgestaltungen mehrere (kurze) Reihen von Öffnungen zueinander beabstandet in einer (langen) Reihe angeordnet - also eine Reihe von Reihen von Öffnungen. Ähnlich der Gestalt einer gestrichelten Doppel-Linie sind sind bei manchen Ausgestaltung entlang einer (langen) Reihe jeweils zwei (oder optional mehr) parallele (kurze) Reihen von Öffnungen angeordnet. Hierdurch lassen sich Anschlüsse oder Bedienelemente, wie z.B. Lichtwellenleiter-Kupplungen, gruppiert an dem Gehäusewandelement anordnen, beispielsweise in Gruppen definiert durch je 1x2, 1x4, 1x6, 1x8, 1x12, 2x2, 2x3, , 2x4, 2x6, 2x8 oder 2x12 Öffnungen, wobei diese Notation am Beispiel "2x4" veranschaulicht als zwei Reihen (d.h. eine Doppelreihe) aus jeweils vier Öffnungen zu verstehen ist. Bei manchen Ausgestaltungen sind also auch mehrere solcher Gruppen zueinander beabstandet in einer (langen) Reihe angeordnet, wodurch sich eine übersichtlichere Strukturierung der Öffnungen für den Benutzer erzielen lässt oder auch ein Zugriff auf dort angeordnete Anschlüsse oder Bedienelemente vereinfachen lässt.

Bei manchen Ausgestaltungen sind das Gehäusewandelement und/oder das Gehäuse insgesamt im Wesentlichen aus Kunststoff, z.B. aus ABS-PC (Acrylnitril-Butadien-Styrol Polycarbonat) oder glasfaserverstärktem Kunststoff, oder aus Metall, z.B. Stahl oder Aluminium, gefertigt. Bei einigen Ausgestaltungen sind das Gehäusewandelement aus Aluminium und das übrige Gehäuse im Wesentlichen aus Kunststoff hergestellt. Somit lässt sich eine Seite des Gehäuses robuster und höherwertiger ausrüsten.

Bei manchen Ausgestaltungen ist das Gehäuse im Wesentlichen quaderförmig. Bei manchen Ausgestaltungen hat das Gehäusewandelement einen im Wesentlichen rechteckigen Umfang. Bei manchen Ausgestaltungen entspricht das Gehäusewandelement hinsichtlich seiner Breite im Wesentlichen der Höhe des Gehäuses und hinsichtlich seiner Breite im Wesentlichen der Breite des Gehäuses.

Bei manchen Ausgestaltungen ist das Gehäusewandelement mit einer Befestigungseinrichtung versehen, um das Gehäuse z.B. an oder in einem Installationsschrank, einem Rahmen, einem Regal, an einer Kabelführungsschiene oder Ähnlichem zu montieren (wenn das Gehäusewandelement an dem Gehäuse montiert ist). Hierbei ist vorzugsweise das Gehäusewandelement so dimensioniert, dass es die gesamte benötigte Trag- und Haltekraft für das Gehäuse (samt der darin befindlichen Vorrichtung) (mechanisch) übertragen kann. Mit anderen Worten, das Gehäuse lässt sich alleine an dem Gehäusewandelement an einem externen Halter befestigen. Bei manchen Ausgestaltungen ist das Gehäusewandelement, vorzugsweise das Gehäuse insgesamt, hinsichtlich seiner Höhe, Breite und/oder Länge für die Montage in einem 19-Inch-Rack (z.B. gemäß EIA 310-D, IEC 60297 und DIN 41494 SC48D) dimensioniert.

Vorzugsweise lässt sich das Etikett durch den Benutzer manuell beschriften, beispielsweise mit einem Bleistift, einem Kugelschreiber oder einem zum Beschriften von Kunststofffolien geeigneten Schreiber. Optional lässt sich das Etikett mit einem Drucker, beispielsweise einem Laser- oder Tintendrucker, beschriften. Bei manchen Ausgestaltungen ist hierfür ein Papierbogen mit mehreren mittels Perforationen trennbaren Etiketten vorgesehen. Zum Bedrucken eines Etiketts lassen sich nutzerseitig mit einer Layout-Vorlage ein oder mehrere Etiketten auf dem Papierbogen mit einer individuellen Beschriftung bedrucken. Der Nutzer kann dann das Etikett aus der Perforierung lösen und an dem Gehäuse, genauer dem Gehäusewandelement mittels der Halterung anbringen. Bei manchen Ausgestaltungen ist das Etikett ein Papier-, Karton- Metallfolien- oder Kunststofffolienstreifen. Bei manchen Ausgestaltungen ist das Etikett flexibel, beispielsweise wie übliches Schreibpapier. Bei manchen Ausgestaltungen ist das Etikett hingegen im Wesentlichen starr. Beispielsweise kann es eine 0,5 mm, 0,8 mm, 1 mm, 1,5 mm oder 2 mm dicke Metall-, Karton- oder Kunststoffplatte sein.

Bei manchen Ausgestaltungen ist zusätzlich zu dem Etikett eine transparente Schutzfolie vorgesehen, die im Wesentlichen der Form des Etiketts entspricht. Vorzugsweise ist die Folie im Wesentlichen gleich lang und gleich breit wie das Etikett. Die Folie lässt sich lose auf das Etikett aufgelegt gemeinsam mit diesem mittels der Halterung an dem Gehäusewandelement anbringen. Beispielsweise lässt sich die Folie von einem Benutzer auf das Etikett nach der Art eines Stapels auflegen und dieser Stapel insgesamt in die Halterung, insbesondere in die Ausnehmung, einschieben oder einlegen.

Bei manchen Ausgestaltungen ist das Gehäuse ein Gehäuse einer Lichtwellenleiter-Anschlussvorrichtung. Hierbei ist das Gehäuse im Wesentlichen quaderförmig und für eine Montage in einem 19-Inch-Rack ausgerüstet. Außerdem ist das Gehäuse mit wenigstens einer ersten Lichtwellenleiter-Kupplung ausgerüstet. Zudem ist das Gehäuse mit einer Spleißkassette für wenigstens ein Lichtwellenleiter-Kabel und/oder wenigstens einer zweiten Lichtwellenleiter-Kupplung ausgerüstet. Hierbei ist das Gehäusewandelement ein Frontwandelement mit einer im Wesentlichen rechteckigen Frontseite, wobei die Frontseite hinsichtlich ihrer Breite im Wesentlichen der Höhe des Gehäuses entspricht und hinsichtlich ihrer Breite im Wesentlichen der Breite des Gehäuses entspricht. Außerdem ist das Gehäusewandelement mit wenigstens einer Öffnung ausgerüstet, in der wenigstens eine der wenigstens einen ersten Lichtwellenleiter-Kupplung angeordnet ist.

### Erläuterung der Zeichnung

Die angefügte Zeichnung veranschaulicht Ausführungsformen der verschiedenen Aspekte der Erfindung. In der Zeichnung zeigen jeweils als schematische Darstellung:
Fig. 1 ein Gehäuse mit teilweise demontierten Gehäusewandelementen
Fig. 2 ein Beispiel eines Gehäusewandelements in rück- und frontseitiger Ansicht, und
Fig. 3 ein weiteres Beispiel eines Gehäusewandelements in rück- und frontseitiger Ansicht.

### Beschreibung von Ausführungsformen anhand der Zeichnung

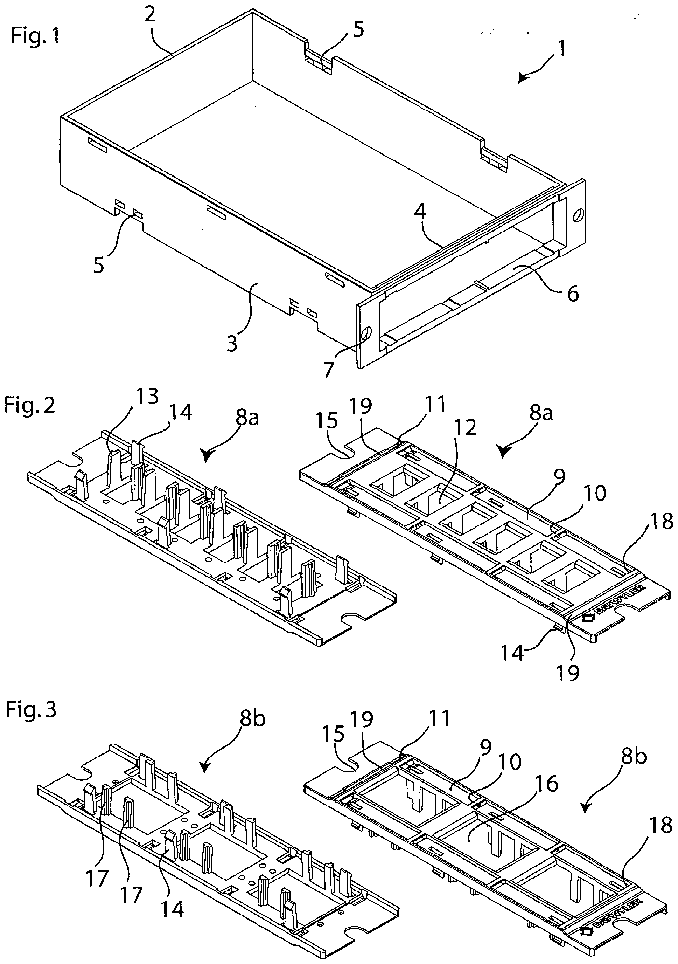

Zunächst sei für einen besseren Überblick das Gehäuse beschrieben. Das in Fig. 1 dargestellte, teilweise geöffnete Gehäuse 1 ist nach der Art eines Rahmens konstruiert. Hierbei sind eine Rückwand 2, Seitenwände 3 und frontseitige Verbindungsstege 4 einteilig aus Kunststoff hergestellt. Unter einem Gehäusewandelement ist vorzugsweise eine (lösbare) Wand des Gehäuses zu verstehen, beispielsweise ein Deckel, ein Boden, eine Rückwand, eine Frontwand oder eine Seitenwand. Bei diesem Ausführungsbeispiel sind ein Boden, ein Deckel und eine Frontwand als lösbare Gehäusewandelemente realisiert, die sich an dem Gehäuse werkzeuglos mittels Rastnasen befestigen lassen. Bedarfsweise lassen sie sich auch wieder lösen, und zwar ohne Spezialwerkzeug, beispielsweise durch einen Benutzer. Hierzu ist das Gehäuse mit Aussparungen 5 ausgerüstet, in die sich die Rastnasen der lösbaren Gehäusewandelemente einrasten lassen.

Frontseitig ist das Gehäuse zudem mit einer Befestigungsplatte 6 ausgerüstet, die eine Öffnung für einen frontseitigen Zugriff in das Innere des Gehäuses besitzt. In diese Öffnung lässt sich die Frontwand mittels Rastnasen (der Frontwand) werkzeuglos einsetzen und befestigen sowie auch wieder lösen. Zudem ist die Befestigungsplatte 6 im Wesentlichen breiter als der Abstand der Seitenwände 3 und ragt somit seitlich über das übrige Gehäuse hinaus. Dieser Umstand sowie die beidseitig jeweils im Bereich des resultierenden Überstands vorgesehenen Öffnungen 7 erlauben eine Montage des Gehäuses z.B. in oder an einem Tragrahmen oder einem 19-Inch-Rack.

Insgesamt ist bei diesem Ausführungsbeispiel das Gehäuse also an drei Seiten öffenbar, indem der Deckel, der Boden und die Frontwand vom Gehäuse lösbar sind. Hingegen unterscheiden sich weitere Ausführungsbeispiele dadurch, dass der Boden und/oder der Deckel nicht lösbar sondern einteilig mit den Seitenwänden und/oder mit der Rückwand ist.

Nachfolgend sei nun das frontseitige Gehäusewandelement erläutert, welches mit Halterungen für Etiketten ausgerüstet ist:
Bei dem in Fig. 2 dargestellten Ausführungsbeispiel ist eine Frontwand 8a mit zwei Halterungen für Etiketten ausgerüstet. Eine solche Halterung hat eine im Querschnitt rechteckige Nut, die jeweils für ein einzelnes, streifenförmiges Etikett vorgesehen ist, beispielsweise ein Papieretikett. Hierbei lässt sich außer dem Etikett eine lose auf das Etikett aufgelegte Schutzfolie zum Schutz des Etiketts gemeinsam mit dem Etikett halten.

Die Halterung ist mit zwei brückenartigen Querstreben 10 als Rückhalteeinrichtung ausgerüstet, welche die Nut 9 überspannen. Ein in die Nut eingelegtes Etikett wird somit von den Querstreben 10 und der Nut 9 vollumfänglich umgriffen und folglich formschlüssig in der Halterung gehalten.

Zum Einlegen, genauer zum Einschieben des Etiketts ist die Frontwand 8a mit jeweils einem Einführschlitz 11 pro Halterung ausgerüstet, wobei der Einführschlitz 11 stirnseitig an einer Stufe 19 auf der Frontseite der Frontwand 8a mündet. Die Stufe 19 ist hierbei durch eine Verjüngung der Frontwand 8a zu ihren (in Längsrichtung gesehenen) Enden hin realisiert.

An dem dem Einführschlitz 11 (in Längsrichtung der Nut 9) gegenüberliegenden Ende der Nut 9 ist die Halterung mit einem Sackloch 18 von der Breite der Nut und einer Höhe von mindestens der Dicke des Etiketts inklusive der Schutzfolie ausgerüstet. In dieses Sackloch 18 ragt das Etikett (und auch die Schutzfolie) in eingelegtem Zustand hinein und wird somit endseitig in der Nut 9 gehalten. Auch ragt es in montiertem Zustand etwas von der Nut 9 aus in den Einführschlitz 11 hinein, sodass es auch an diesem Ende gehalten wird.

Beidseitig in Längsrichtung der Nut 9 sind die Stirnseiten der Nut 9 als Anschläge 11 für ein eingelegtes Etikett ausgebildet, sodass das Etikett gegen Verschieben gesichert ist. Diese Halterung gestattet somit, dass sich das Etikett werkzeuglos durch den Benutzer anbringen und auch wieder entnehmen lässt.

Im Übrigen ist die Halterung einteilig mit der Frontwand 8a ausgebildet, sodass kein weiteres Bauteil zur Befestigung eines Etiketts nötig ist. Auch ragt die Halterung nicht über die Frontfläche der Frontwand 8a hinaus, sondern schließt bündig mit dieser ab.

Außerdem ist die Frontwand 8a mit sechs in einer Reihe angeordneten Öffnungen 12 ausgerüstet, die zum Einsetzen und Befestigen von in den Öffnungen 12 einrastbaren Lichtwellenleiter-Kupplungen (jeweils eine Kupplung pro Öffnung 12) vorgesehen sind. Hierzu sind auf der von der Frontseite der Frontwand 8a abgewandten Seite Vorsprünge 13 als Widerlager für die Kupplungen angeordnet. Außerdem ist die Frontwand 8a mit Rastnasen 14 ausgerüstet, mit der sich die Frontwand 8a frontseitig an dem Gehäuse, genauer an der Befestigungsplatte 6 einrasten lässt. Hierbei ist die Frontwand 8a, insbesondere auch durch einen Nutzer, bei Bedarf wieder lösbar und anschließend erneut an dem Gehäuse befestigbar.

Im Bereich der Öffnungen 7 der Befestigungsplatte 6 sind Aussparungen 15 an der Frontwand 8a angebracht. So lässt sich das (fertig montierte) Gehäuse (mit daran befestigter Frontwand 8a) beispielsweise an einem Rahmen und/oder einem Regal anschrauben.

Ein weiteres, in Fig. 3 dargestelltes Ausführungsbeispiel unterscheidet sich von den zuvor beschriebenen dadurch, dass bei einer Frontwand 8b Öffnungen 16 zum Einsetzen und Befestigen von jeweils zwei Lichtwellenleiter-Kupplungen vorgesehen sind, beispielsweise von zwei LC-Kupplungen pro Öffnung 16. Die Frontwand 8b weist insgesamt drei solche Öffnungen 16 auf, deren Fläche doppelt so groß als die der Öffnungen 12 ist, sodass die Frontwand 8b in Summe gleich viele Kupplungen aufnehmen kann wie die Frontwand 8a. Dementsprechend sind auf der der Frontseite abgewandten Seite jeweils eine doppelte Anzahl von Vorsprüngen pro Öffnung 16 vorgesehen, also zwei pro Kupplung, sprich vier pro Öffnung 16.

Im Übrigen wird durch die Stege 10 ein in die Nut 9 eingelegtes Etikett zumindest visuell in drei Bereiche unterteilt, wobei sich bei Ausführungsbeispielen gemäß Fig. 2 jeweils ein Bereich zwei Öffnungen 12 und bei Ausführungsbeispielen gemäß Fig. 3 jeweils ein Bereich einer einzelnen Öffnung 16 zuordnen lässt. Bei anderen Ausführungsbeispielen ist eine solche Zuordnung hingegen nicht offensichtlich, da dort die Stege nicht (in einer Projektion betrachtet) zwischen den Öffnung liegen, sondern hinsichtlich der Öffnungen beliebig angeordnet sein können. Hierdurch lässt sich die Anzahl der Stege auf eine zum sicheren Halten des Etiketts nötige Mindestzahl reduzieren, beispielsweise auf einen oder zwei Stege pro Halterung.

Weitere Ausführungsbeispiele unterscheiden sich dadurch, dass entlang der Reihe von Öffnungen nur eine Halterung oder nur eine Reihe von Halterungen angeordnet ist, also nicht beidseitig der Reihe von Öffnungen 12, 16 jeweils eine Halterung bzw. eine Reihe von Halterungen.

Weitere Ausführungsbeispiele unterscheiden sich dadurch, dass die Nut nicht durchgehend entlang der Reihe von Öffnungen 12, 16 verläuft. Stattdessen sind entlang der Reihe drei oder sechs einzelne Halterungen für jeweils ein Etikett angeordnet. Hierbei entspricht die Länge der Nut im Wesentlichen der Breite der Öffnung 12, 16 in Richtung der Reihe der Öffnungen 12, 16.

Weitere Ausführungsbeispiele unterscheiden sich dadurch, dass das Etikett anstatt mit den Querstreben 10 durch zwei beidseitig entlang der Nut verlaufenden Schienen oder durch eine Hinterschneidung, einen Haltefinger oder eine Rastnase zurückgehalten werden.

## Patentansprüche

1. Gehäusewandelement (8a, 8b) mit wenigstens einer einteilig mit dem Gehäusewandelement (8a, 8b) ausgebildeten Halterung für ein Etikett, wobei
die Halterung auf einer Außenseite des Gehäusewandelements (8a, 8b) angeordnet ist,
die Halterung eine Ausnehmung (9) zum Einlegen oder Einschieben des Etiketts aufweist, wobei die Halterung ausgestaltet ist, das Etikett werkzeuglos an dem Gehäusewandelement (8a, 8b) anzubringen und auch von diesem zu lösen, und
die Halterung eine Rückhalteeinrichtung aufweist, die ausgestaltet ist, um ein selbstständiges Lösen des Etiketts zu verhindern,
wobei die Rückhalteeinrichtung wenigstens eine Schiene zum Einschieben des Etiketts, eine Hinterschneidung, einen Haltefinger, eine Rastnase, einen die Ausnehmung überspannenden Steg (10) oder eine Öse zum zumindest teilweisen Umgreifen des Etiketts aufweist, und
wobei die Halterung ein Sackloch (18) aufweist, in das sich das Etikett einschieben und endseitig halten lässt.

2. Gehäusewandelement (8a, 8b) nach Anspruch 1, wobei die Halterung mit einem Einführschlitz (11) für die Ausnehmung ausgerüstet ist, wobei der Einführschlitz an Stirnfläche des Gehäusewandelements (8a, 8b) angeordnet ist.

3. Gehäusewandelement (8a, 8b) nach einem der vorhergehenden Ansprüche, wobei die Halterung bündig mit einer Außenseite des Gehäusewandelements (8a, 8b) ausgebildet ist.

4. Gehäusewandelement (8a, 8b) nach einem der vorhergehenden Ansprüche, wobei das Gehäusewandelement (8a, 8b) wenigstens eine Öffnung (12, 16) aufweist, wobei die wenigstens eine Halterung und die wenigstens eine Öffnung (12, 16) in beabstandeten parallelen Reihen angeordnet sind.

5. Gehäuse mit einem Gehäusewandelement (8a, 8b) nach einem der vorhergehenden Ansprüche 1 bis 4.

6. Gehäuse nach Anspruch 5, wobei das Gehäusewandelement (8a, 8b) werkzeuglos an dem Gehäuse befestigbar ist und auch von diesem lösbar ist.

7. Gehäuse nach Anspruch 5 oder 6, wobei das Gehäuse für eine Lichtwellenleiter-Anschlussvorrichtung eingerichtet ist, wobei
das Gehäuse im Wesentlichen quaderförmig ist und für eine Montage in einem 19-Inch-Rack ausgerüstet ist,
das Gehäuse mit wenigstens einer ersten Lichtwellenleiter-Kupplung ausgerüstet ist,
das Gehäuse mit einer Spleißkassette für wenigstens ein Lichtwellenleiter-Kabel und/oder wenigstens einer zweiten Lichtwellenleiter-Kupplung ausgerüstet ist,
das Gehäusewandelement (8a, 8b) ein Frontwandelement mit einer im Wesentlichen rechteckigen Frontseite ist, wobei die Frontseite hinsichtlich ihrer Breite im Wesentlichen der Höhe des Gehäuses entspricht und hinsichtlich ihrer Breite im Wesentlichen der Breite des Gehäuses entspricht, und
das Gehäusewandelement (8a, 8b) mit wenigstens einer Öffnung ausgerüstet ist, in der wenigstens eine der wenigstens einen ersten Lichtwellenleiter-Kupplung angeordnet ist.

## Claims

1. Housing wall element (8a, 8b) comprising at least one mounting element, formed integrally with the housing wall element (8a, 8b), for a label, wherein
the mounting element is arranged on an outer face of the housing wall element (8a, 8b),
the mounting element comprises a recess (9) for the insertion of the label, wherein the mounting element is designed to attach the label to the housing wall element (8a, 8b), and detach it therefrom, without tools, and
the mounting element comprises a retaining means which is designed to prevent the label from detaching by itself,
wherein the retaining means comprises at least one rail for the insertion of the label, an undercut, a retaining finger, an engaging lug, a strip (10) spanning the recess, or a loop for surrounding the label at least in part, and
wherein the mounting element comprises a blind hole (18) into which the label can be inserted and retained at one end.

2. Housing wall element (8a, 8b) according to claim 1, wherein the mounting element is provided with an insertion slot (11) for the recess, wherein the insertion slot is arranged in an end face of the housing wall element (8a, 8b).

3. Housing wall element (8a, 8b) according to either of the preceding claims, wherein the mounting element is flush with an outer face of the housing wall element (8a, 8b).

4. Housing wall element (8a, 8b) according to any of the preceding claims, wherein the housing wall element (8a, 8b) comprises at least one opening (12, 16), wherein the at least one mounting element and the at least one opening (12, 16) are arranged in spaced parallel rows.

5. Housing comprising a housing wall element (8a, 8b) according to any of the preceding claims 1 to 4.

6. Housing according to claim 5, wherein the housing wall element (8a, 8b) can be fastened to the housing, and detached therefrom, without tools.

7. Housing according to either claim 5 or claim 6, wherein the housing is designed for an optical waveguide connection device, wherein
the housing is substantially cuboidal and provided for mounting in a 19-inch rack,
the housing is provided with at least one first optical waveguide coupling,
the housing is provided with a splice box for at least one optical waveguide cable and/or with at least one second optical waveguide coupling,
the housing wall element (8a, 8b) is a front wall element having a substantially rectangular front face, wherein the front face substantially corresponds, with respect to the width thereof, to the height of the housing and substantially corresponds, with respect to the width thereof, to the width of the housing,
the housing wall element (8a, 8b) is provided with at least one opening in which at least one of the at least one first optical waveguide couplings is arranged.

## Revendications

1. Elément de paroi de boîtier (8a, 8b) comprenant au moins un élément de retenue pour une étiquette formé d'une seule pièce avec l'élément de paroi de boîtier (8a, 8b), dans lequel
l'élément de retenue est agencé sur une face extérieure de l'élément de paroi de boîtier (8a, 8b),
l'élément de retenue présente un évidement (9) pour l'insertion ou l'introduction de l'étiquette, dans lequel l'élément de retenue est conçu pour appliquer l'étiquette sur l'élément de paroi de boîtier (8a, 8b) ainsi que pour l'en détacher sans outil, et
l'élément de retenue présente un dispositif de retenue, qui est conçu pour empêcher l'étiquette de se détacher tout seule,
dans lequel le dispositif de retenue présente au moins un rail pour l'introduction de l'étiquette, un dégagement, un doigt de retenue, un ergot d'encliquetage, une patte (10) longeant l'évidement ou un oeillet pour enserrer au moins en partie l'étiquette, et
dans lequel l'élément de retenue présente un trou borgne (18) dans lequel l'étiquette peut être introduite et retenue en extrémité.

2. Elément de paroi de boîtier (8a, 8b) selon la revendication 1, dans lequel l'élément de retenue est équipé d'une fente d'introduction (11) pour l'évidement, dans lequel la fente d'introduction est agencée sur la face frontale de l'élément de paroi de boîtier (8a, 8b).

3. Elément de paroi de boîtier (8a, 8b) selon l'une quelconque des revendications précédentes, dans lequel l'élément de retenue est formé au même niveau qu'une face extérieure de l'élément de paroi de boîtier (8a, 8b).

4. Elément de paroi de boîtier (8a, 8b) selon l'une quelconque des revendications précédentes, dans lequel l'élément de paroi de boîtier (8a, 8b) présente au moins une ouverture (12, 16), dans lequel le au moins un élément de retenue et la au moins une ouverture (12, 16) sont agencés en rangées parallèles espacées.

5. Boîtier comprenant un élément de paroi de boîtier (8a, 8b) selon l'une des revendications précédentes 1 à 4.

6. Boîtier selon la revendication 5, dans lequel l'élément de paroi de boîtier (8a, 8b) peut être fixé au boîtier et peut également en être détaché sans outil.

7. Boîtier selon la revendication 5 ou 6, dans lequel le boîtier est conçu pour un dispositif de connexion à fibre optique, dans lequel
le boîtier est sensiblement parallélépipédique et est équipé pour être monté dans un râtelier de 19 pouces,
le boîtier est équipé d'au moins un premier dispositif d'accouplement de fibre optique,
le boîtier est équipé d'une cassette d'épissage pour au moins un câble à fibre optique et/ou d'au moins un deuxième dispositif d'accouplement de fibre optique,
l'élément de paroi de boîtier (8a, 8b) est un élément de paroi avant pourvu d'une face avant sensiblement rectangulaire, dans lequel la largeur de la face avant correspond sensiblement à la hauteur du boîtier et la largeur de ladite face avant correspond sensiblement à la largeur du boîtier, et
l'élément de paroi de boîtier (8a, 8b) est équipé d'au moins une ouverture dans laquelle est agencé au moins un du au moins un premier dispositif d'accouplement de fibre optique.
